(19) **Europäisches Patentamt**

**European Patent Office**

**Office européen des brevets**

(11) **EP 1 466 186 B1**

(12) **EUROPÄISCHE PATENTSCHRIFT**

(45) Veröffentlichungstag und Bekanntmachung des Hinweises auf die Patenterteilung:
**14.06.2006 Patentblatt 2006/24**

(21) Anmeldenummer: **02793076.7**

(22) Anmeldetag: **18.12.2002**

(51) Int Cl.:
*G01R 33/07* (2006.01)    *G01D 5/14* (2006.01)

(86) Internationale Anmeldenummer:
**PCT/EP2002/014508**

(87) Internationale Veröffentlichungsnummer:
**WO 2003/060537 (24.07.2003 Gazette 2003/30)**

(54) **SENSORSYSTEM UND VERFAHREN ZUM BETRIEB DES SENSORSYSTEMS**

SENSOR SYSTEM AND METHOD FOR OPERATING THE SENSOR SYSTEM

SYSTEME DETECTEUR ET PROCEDE ET SON MODE DE FONCTIONNEMENT

(84) Benannte Vertragsstaaten:
**AT BE BG CH CY CZ DK EE ES FI FR GB GR IE IT LI LU MC NL PT SE SI SK TR**

(30) Priorität: **18.01.2002 DE 10201875**

(43) Veröffentlichungstag der Anmeldung:
**13.10.2004 Patentblatt 2004/42**

(73) Patentinhaber: **austriamicrosystems AG**
**8141 Unterpremstätten (AT)**

(72) Erfinder:
• **STEELE, Colin**
**A-8561 Söding (AT)**
• **ROSSMANN, Siegfried**
**A-9125 Kuehnsdorf (AT)**
• **PERSKE, Frank**
**A-8054 Graz (AT)**

(74) Vertreter: **Epping - Hermann - Fischer**
**Ridlerstrasse 55**
**80339 München (DE)**

(56) Entgegenhaltungen:
**US-A- 4 599 564          US-A- 5 621 319**
**US-A- 5 747 995          US-A- 5 844 427**

**Beschreibung**

Die Erfindung betrifft ein Sensorsystem mit einer Anordnung von Sensoren, bei der jeder Sensor ein elektrisches oder magnetisches Feld erfaßt und an seinen Sensorausgängen ein elektrisches Sensorsignal ausgibt. Die Sensorausgänge sind miteinander verschaltet. Darüber hinaus betrifft die Erfindung ein Verfahren zum Betrieb des Sensorsystems.

Aus der Druckschrift DE 199 43 128 A1 ist eine Hall-Sensoranordnung bekannt, bei der mehrere Hall-Sensoren ortsfest angeordnet und in einer festen Konfiguration miteinander verschaltet sind. Eine solche Sensoranordnung hat den Nachteil, daß sie aufgrund der festen Verschaltung der Sensoren eine geringe Flexibilität bei der Messung von beispielsweise magnetischen Feldern aufweist. Insbesondere ist die bekannte Sensoranordnung nicht zur zwei- beziehungsweise dreidimensionalen Messung magnetischer Feldverteilungen geeignet.

Das Dokument US-A-5 747 995 offenbart ein Sensorsystem mit einer Anordnung von Hallelementen, die ein magnetisches oder elektrisches Feld erfassen und an seinen Ausgängen ein elektrisches Signal ausgeben.

Ziel der vorliegenden Erfindung ist es daher, ein Sensorsystem anzugeben, das eine Vielzahl von Einsatzmöglichkeiten aufweist und das insbesondere zur Analyse von zwei- und dreidimensionalen magnetischen Feldverteilungen geeignet ist.

Dieses Ziel wird erfindungsgemäß durch ein Sensorsystem nach Patentanspruch 1 erreicht. Weitere vorteilhafte Ausgestaltungen der Erfindung und ein Verfahren zum Betrieb des Sensorsystems sind den weiteren Ansprüchen zu entnehmen.

Es wird ein Sensorsystem angegeben, das eine Anordnung von Sensoren aufweist. Jeder der Sensoren erfaßt ein elektrisches oder magnetisches Feld und gibt an seinen Gängen ein elektrisches Sensorsignal aus. Für das Sensorsystem können gleichartige oder aber auch verschiedenartige Sensoren verwendet werden.

Jeder der Sensoren ist mit einem Signalmodulator verbunden, wobei die Eingänge des Signalmodulators mit den Sensorausgängen des betreffenden Sensors verbunden sind. Jeder Signalmodulator weist wenigstens zwei Steuerzustände auf. In einem ersten Steuerzustand liegt am Signalmodulatorausgang als Sensorendsignal das entsprechende Sensorgrundsignal an. In einem zweiten Steuerzustand liegt am Signalmodulatorausgang als Sensorendsignal das invertierte Sensorgrundsignal an.

Darüber hinaus weist das Sensorsystem eine Vorrichtung zur Addition der Sensorendsignale zu einem Systemsignal auf.

Das Sensorsystem hat den Vorteil, daß aufgrund der unterschiedlichen Steuerzustände eines jeden Signalmodulators eine Vielzahl von Konfigurationen für das Sensorsystem definiert werden kann. Das Sensorsystem ist somit flexibel einsetzbar und insbesondere zur Analyse von zwei- beziehungsweise dreidimensionalen Magnetfeldern geeignet. Darüber hinaus ist ein solches Sensorsystem zur Erfassung linearer magnetischer oder elektrischer Felder, zur Erfassung von Ortsverschiebungen von linearen oder axialen sinusförmig verteilten magnetischen Feldern geeignet.

Es wird darüber hinaus ein Verfahren zum Betrieb des Sensorsystems angegeben, das erst mit dem erfindungsgemäßen Sensorsystem ermöglicht wird. Alle Steuerzustände der Signalmodulatoren zusammen definieren dabei die Konfiguration des Sensorsystems. Das Betriebsverfahren weist die folgenden Schritte auf:

In einem ersten Schritt wird das Sensorsystem auf eine erste Konfiguration gelegt. Es wird das von dem Sensorsystem ausgegebene Systemsignal von einer geeigneten Vorrichtung erfaßt und gespeichert.

In einem zweiten Schritt des Betriebsverfahrens wird die Konfiguration des Sensorsystems von der ersten Konfiguration in eine zweite Konfiguration geändert. Die zweite Konfiguration unterscheidet sich dabei von der ersten Konfiguration.

In einem dritten Schritt wird das in der zweiten Konfiguration vom Sensorsystem ausgegebene Systemsignal wiederum in einer geeigneten Vorrichtung eingelesen und gespeichert.

Gegebenenfalls können auch noch weitere Konfigurationen eingestellt und die vom Sensorsystem ausgegebenen Signale eingelesen und gespeichert werden.

In einem weiteren Verfahrensschritt erfolgt schließlich die Durchführung einer Rechenoperation mit dem ersten und dem zweiten und gegebenenfalls weiteren Systemsignalen. Mit Hilfe dieser Rechenoperation können Rückschlüsse auf die flächige beziehungsweise räumliche Verteilung des zu erfassenden magnetischen oder elektrischen Feldes geschlossen werden.

In dem Sensorsystem können als Sensoren beispielsweise Hall-Sensoren verwendet werden. Solche Hall-Sensoren können auf der Basis von Siliziumsensoren als vertikale oder laterale Hall-Sensoren ausgeführt sein. Es kommen aber auch magnetfeldabhängige Widerstände als Sensoren in Frage.

Die von den Hall-Sensoren ausgegebenen Sensorgrundsignale können durch einen Steilheitsverstärker verstärkt werden. Dieser Steilheitsverstärker ist dann zwischen jedem Sensor und dem entsprechenden Signalmodulator geschaltet. Die Verwendung von Steilheitsverstärkern zur Verstärkung der Sensorgrundsignale ermöglicht es, einzelne Sensoreinheiten, bestehend aus einem Sensor und dem dazu gehörigen Signalmodulator zueinander parallel zu verschalten. Mit Hilfe einer solchen Parallelschaltung wird es möglich, die Ströme der Sensorendsignale zu einem Systemsignal zu addieren.

Die Signalmodulatoren können mit einer Kontroll-Logikschaltung verbunden sein, welche es erlaubt, das Umschalten zwischen zwei Steuerzuständen eines Signalmodulators mittels digitaler Kontrollwörter zu realisieren. Dies erlaubt ein besonders schnelles Umschalten zwischen zwei Steuerzuständen eines Signalmodulators und mithin zwischen zwei Konfigurationen des Sensorsystems.

In einer beispielhaften Ausführungsform des Sensorsystems können die Sensoren in einer Ebene angeordnet sein. Innerhalb einer solchen Ebene wiederum können die Sensoren in Zeilen beziehungsweise Spalten angeordnet sein, welche zueinander orthogonal sind. Dadurch wird ein schachbrettartiges Raster von Sensoren realisiert.

Im folgenden wird die Erfindung anhand von Ausführungsbeispielen und den dazugehörigen Figuren näher erläutert.

Figur 1      zeigt einen Baustein eines Sensorsystems in einer schematischen Schaltungsanordnung.

Figur 2      zeigt beispielhaft ein erfindungsgemäßes Sensorsystem in einer schematischen Schaltungsanordnung.

Figur 3A      zeigt ein erfindungsgemäßes Sensorsystem in einer ersten Konfiguration.

Figur 3B      zeigt das Sensorsystem aus Figur 3A in einer weiteren Konfiguration.

Figur 4A      zeigt einen zylinderförmigen Permanentmagneten, dessen Orientierung relativ zum Sensorsystem aus den Figuren 3A und 3B bestimmt wird.

Figur 4B      zeigt die tangentiale Magnetfeldamplitude auf der X-Achse des Magneten aus Figur 4A entlang zentrischer Kreise mit dem Radius X um die Symmetrieachse.

Figur 4C      zeigt die relative Lage eines Sensorsystems gemäß

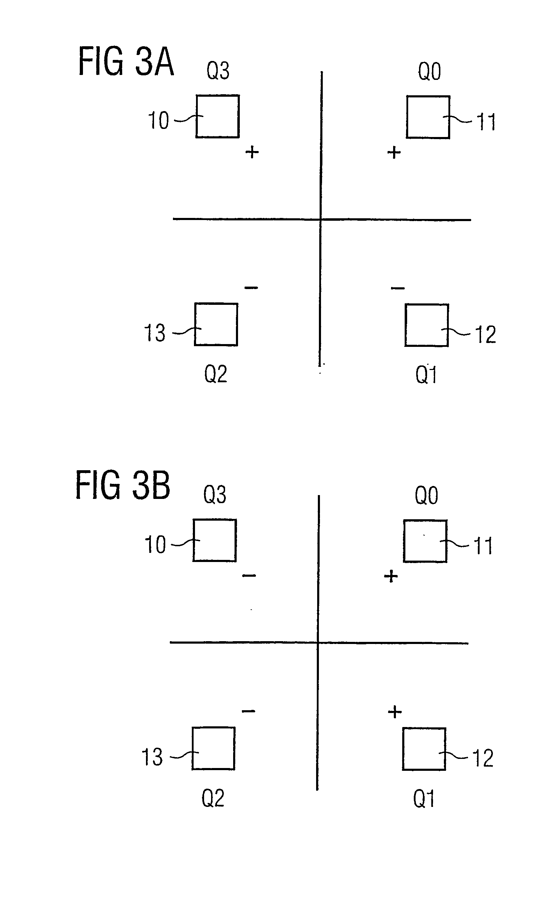

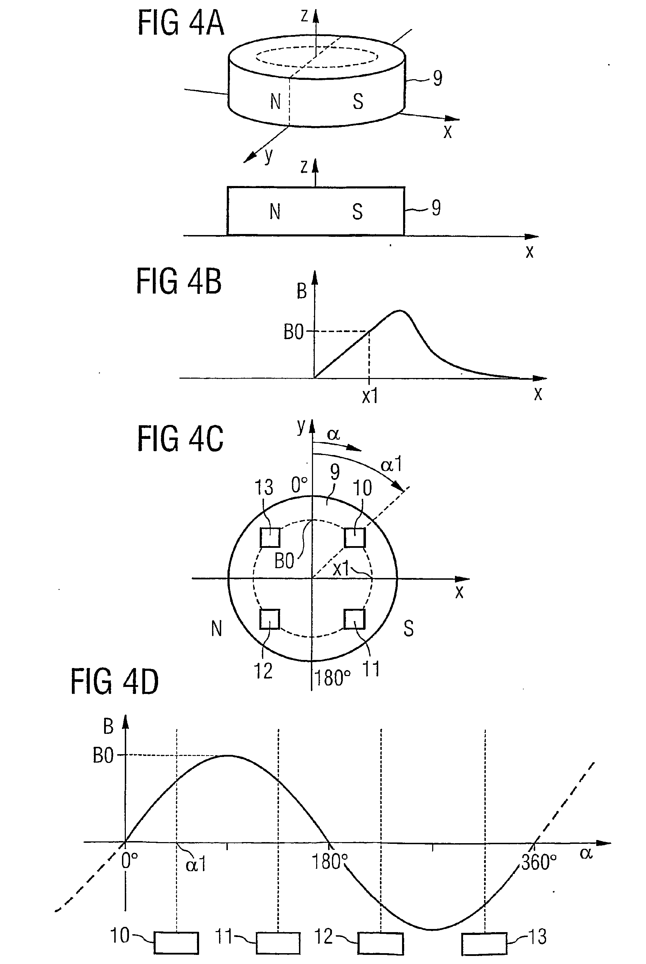

Figur 3A      zu einem Magneten gemäß Figur 4A in Draufsicht.

Figur 4D      zeigt die tangentiale Magnetfeldamplitude.

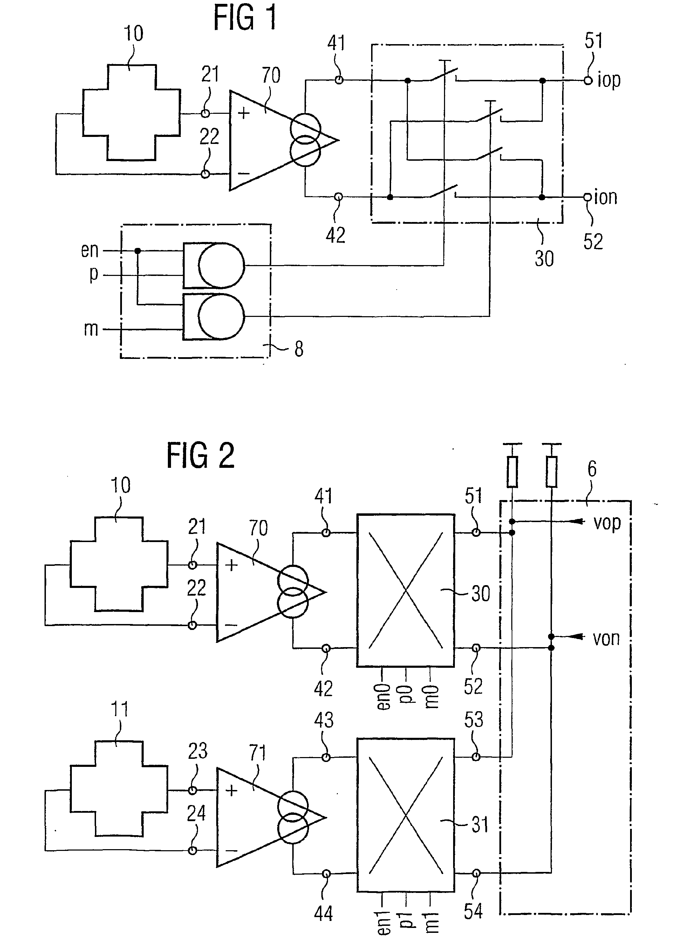

Figur 1 zeigt einen Hall-Sensor 10, dessen Ausgänge 21, 22 mit einem Steilheitsverstärker 70 verbunden sind. Die Ausgänge des Steilheitsverstärkers 70 wiederum sind mit den Eingängen 41, 42 eines Signalmodulators 30 verbunden. An den Ausgängen 51, 52 des Signalmodulators 30 liegt das Sensorendsignal iop, ion an. Der Ausgangsmodulator 30 ist mit einer Kontroll-Logikschaltung 8 verbunden, die verschiedene Steuerzustände in dem Signalmodulator 30 erzeugen kann. Dazu werden an den Eingängen EN, P, M der Kontroll-Logikschaltung 8 digitale Signale angelegt, die zu digitalen Kontrollwörtern zusammengefaßt werden können. Der Eingang EN der Kontroll-Logikschaltung 8 steht dabei für das Einschalten des Signalmodulators 30. Sobald am Eingang EN der Kontroll-Logikschaltung 8 das Signal "High" anliegt, liefert der Signalmodulator 30 an seinen Ausgängen 51, 52 ein Signal, das vom Signal des Häll-Sensors 10 abhängig ist. Falls am Eingang EN der Kontroll-Logikschaltung 8 das Signal "Low" anliegt, ist der Signalmodulator 30 deaktiviert, das heißt, daß die Ausgänge 51, 52 des Signalmodulators 30 nicht mit den Sensorausgängen 21, 22 des Hall-Sensors 10 verbunden sind. Bei aktiviertem Signalmodulator 30 besteht durch Anlegen entsprechender Signale an die Eingänge P, M der Kontroll-Logikschaltung 8 die Möglichkeit, an den Ausgängen 51, 52 des Signalmodulators 30 entweder das Sensorgrundsignal des Hall-Sensors 10 oder das invertierte Grundsignal des Hall-Sensors 10 zu erhalten. Dazu muß lediglich am Eingang P das Signal "High" beziehungsweise am Eingang M das Signal "High" angelegt werden.

Insgesamt weist also der Signalmodulator 30 aus Figur 1 drei verschiedene Steuerzustände auf. Diese Steuerzustände werden charakterisiert durch 0 (Signalmodulator 30 deaktiviert), + (Addition, das heißt, daß das Sensorendsignal iop, ion dem Sensorgrundsignal entspricht) und - (das heißt, daß das Sensorendsignal das invertierte Sensorgrundsignal darstellt) charakterisiert.

Figur 2 zeigt die Verschaltung zweier Sensoren 10 aus Figur 1 zu einem Sensorsystem. Jedem Sensor 10, 11 ist ein Signalmodulator 30, 31 zugeordnet, der über einen Steilheitsverstärker 70, 71 mit dem entsprechenden Sensor 10, 11 verbunden ist. Die Sensorausgänge 21, 22 des Sensors 10 beziehungsweise die Sensorausgänge 23, 24 des Sensors 11 sind mit den Sensoreingängen 41, 42 des Signalmodulators 30 beziehungsweise den Eingängen 43, 44 des Signalmodulators 31 verbunden. An den Ausgängen 51, 52 beziehungsweise 53, 54 der Signalmodulatoren 30, 31 liegen Sensorendsignale an, die durch die Vorrichtung 6 zur Addition aufsummiert werden.

Gemäß Figur 2 ist die Vorrichtung 6 zur Addition eine einfache Parallelschaltung der an den Ausgängen 51, 52 beziehungsweise 53, 54 der Signalmodulatoren 30, beziehungsweise 31 anliegenden Ausgangsspannungen. Bezüglich der in diesem Fall gemessenen Ströme ergibt sich eine Addition der Sensorendsignale. Die summierten Ströme erzeugen an den Widerständen 91, 92 einen Spannungsabfall, der als Systemsignal VOP, VON ausgelesen werden kann.

Die Signalmodulatoren 30, 31 enthalten jeweils eine Kontroll-Logikschaltung, die jedoch in Figur 2 nicht dargestellt ist. Es sind lediglich die Eingänge der Kontroll-Logikschaltungen mit EN0, P0, M0 für den Signalmodulator 30 beziehungsweise EN1, P1, M1 für den Signalmodulator 31 angegeben.

Figur 3 zeigt die Anordnung von vier Sensoren 10, 11, 12, 13 in einem quadratischen Muster, wobei die Fläche im Quadranten Q0, Q1, Q2, Q3, unterteilt ist. In jedem Quadranten Q0, Q1, Q2, Q3 befindet sich einer der Sensoren 10, 11, 12, 13. Die Konfiguration des Sensorsystems aus Figur 3A ist angegeben durch das Zeichen + in den Quadranten Q0, Q3 und durch das Zeichen - in den Quadranten Q2, Q1. Gemäß Figur 3B weist das Sensorsystem aus Figur 3A eine andere Konfiguration auf, wobei das Zeichen + für die Quadranten Q1 und Q0 und das Zeichen - für die Quadranten Q2 und Q3 gilt. Durch die Zeichen + beziehungsweise - wird der Steuerzustand des in dem jeweiligen Quadranten Q0, Q1, Q2, Q3 befindlichen Sensors 10, 11, 12, 13 angedeutet. Mit Hilfe eines Sensorsystems in zwei verschiedenen Konfigurationen K1 und K2 gemäß den Figuren 3A und 3B kann beispielsweise der Drehwinkel eines Magneten gemäß Figur 4A über der Sensoranordnung gemessen werden.

Figur 4A zeigt einen zylinderförmigen Permanentmagneten, dessen Orientierung relativ zum Sensorsystem aus den Figuren 3A und 3B bestimmt wird.

Ein solcher Magnet 9 ist dargestellt in Figur 4A. Er weist die Form einer Scheibe auf, die eine Symmetrieachse entlang der Z-Achse besitzt. Die beiden Hälften der Scheibe sind diametral magnetisiert und weisen mithin einen magnetischen Nordpol N und einen magnetischen Südpol S auf.

Figur 4B zeigt die tangentiale Komponente des Magnetfeldes bezüglich Kreisen um die Symmetrieachse Z als Magnetfeldamplitude B, wobei das Magnetfeld am Schnittpunkt eines Kreises mit der X-Achse aufgetragen ist. Für einen Kreis mit dem Radius X1 hat die tangentiale Komponente des Magnetfelds die Magnetfeldamplitude B0.

Figur 4C zeigt die Anordnung eines Magneten 9 gemäß Figur 4A über einem Sensorsystem gemäß Figur 3A in Draufsicht. Die Sensoren 10, 11, 12, 13 liegen auf einem Kreis um die Symmetrieachse Z des Magneten 9, wobei der Radius des Kreises X1 beträgt. Die Symmetrieachse Z des Magneten 9, der Sensor 10 und die Y-Achse des Magneten 9 schließen den Winkel $\alpha 1$ ein. Der Winkel $\alpha 1$ beträgt 45°.

Figur 4D zeigt in Abhängigkeit vom Winkel $\alpha$ aus Figur 4C die tangentiale Magnetfeldamplitude B entlang des Kreises mit dem Radius x1 gemäß Figur 4C. Die Position der Sensoren 10, 11, 12, 13 ist in Figur 4D angedeutet. Der maximale Wert der Magnetfeldamplitude ergibt sich für $\alpha = 90°$. Hier hat die Magnetfeldamplitude den Wert B0. Der Magnet 9 kann nun gemäß Figur 4C in Pfeilrichtung gegenüber der Sensoranordnung gedreht werden. Bezeichnet man den Drehwinkel des Magneten 9 gegenüber dem Sensorsystem mit $\alpha$, so ergeben sich mit

$$G_{Hall} = \text{die elektrische Verstärkung der Hall-Sensoren}$$

die folgenden Zusammenhänge:

Das magnetische Quellenfeld $B_{Quelle}$ am Ort eines jeden Sensors 10, 11, 12, 13 wird bestimmt durch den Drehwinkel $\alpha$ gemäß:

$$B_{Quelle} = B0 \cdot \text{Sinus } (\alpha).$$

In der Konfiguration gemäß Figur 3A erhält man als Systemsignal $V_{K1}$:

$$V_{K1} = B0 \cdot G_{Hall} \cdot ((\text{Sinus } (\alpha + 45) - \text{Sinus } (\alpha + 135) - \text{Sinus } (\alpha + 225) + \text{Sinus } (\alpha + 315)))$$

Daraus ergibt sich durch Umformen:

$$V_{K1} = 2\sqrt{2} \cdot B0 \cdot G_{Hall} \cdot \text{Sinus } (\alpha).$$

Ein anderes Signal erhält man mit der Konfiguration des Sensorsystems gemäß Figur 3B:

$$V_{K2} = B0 \cdot G_{Hall} \, ((\text{Sinus } (\alpha + 45) + \text{Sinus } (\alpha + 135) - \text{Sinus } (\alpha + 225) - \text{Sinus } (\alpha + 315))).$$

Umformen liefert:

$$V_{K2} = 2\sqrt{2} \cdot B0 \cdot G_{Hall} \cdot \text{Cosinus } (\alpha).$$

Durch eine Rechenoperation kann in einfacher Art und Weise aus den Signalen $V_{K1}$ und $V_{K2}$ der Drehwinkel des Magneten 9 gegenüber dem Sensorsystem berechnet werden. Dazu wird folgendes berechnet:

$$\alpha = \text{ARCTAN } (V_{K1} : V_{K2}).$$

Diese Berechnung kann beispielsweise mit Hilfe des erfindungsgemäßen Verfahrens durchgeführt werden, in dem das Sensorsystem in einem ersten Zeitpunkt in einer Konfiguration K1 mißt und der gemessene Wert des Systemsignals (VOP, VON) gespeichert wird. Anschließend wird das Sensorsystem wie aus den Figuren 3a beziehungsweise 3b ersichtlich, in eine andere Konfiguration K2 gebracht. Anschließend wird das Systemsignal VOP, VON wieder erfaßt und gespeichert. Anschließend kann die oben angegebene Rechenoperation durchgeführt werden.

Durch die Möglichkeit der Steuerung der Signalmodulatoren mittels digitaler Kontrollwörter kann das Umschalten zwischen verschiedenen Konfigurationen K1, K2 des Sensorsystems in sehr kurzer Zeit, beispielsweise im Abstand von einigen $\mu$s erfolgen. Dadurch ist eine hohe Flexibilität und eine hohe Schnelligkeit des Sensorsystems gewährleistet.

**Patentansprüche**

1. Sensorsystem mit einer Anordnung von Sensoren (10, 11, 12, 13), bei der jeder Sensor (10, 11, 12, 13) ein magnetisches oder elektrisches Feld erfaßt und an seinen Sensorausgängen (21, 22, 23, 24) ein elektrisches Sensorgrundsignal ausgibt, **dadurch gekennzeichnet, dass**

   - ein Signalmodulator (30, 31) vorgesehen ist, wobei die Sensorausgänge (21, 22) eines jeden Sensors (10, 11, 12, 13) mit den Eingängen (41, 42, 43, 44) des Signalmodulators (30, 31) verbunden sind, wobei der Signalmodulator (30, 31) wenigstens zwei Steuerzustände aufweist, wobei in einem ersten Steuerzustand an den Ausgängen (51, 52) des Signalmodulators (30, 31) als Sensorendsignal (iop, ion) das entsprechende Sensorgrundsignal und in einem zweiten Steuerzustand des Signalmodulators (30, 31) an dessen Ausgängen (51, 52) als Sensorendsignal (iop, ion) das invertierte Sensorgrundsignal des entsprechenden Sensors (10, 11, 12, 13) anliegt,
   - und dass eine Vorrichtung (6) zur Addition der Sensorendsignale (iop, ion) zu einem Systemsignal (VOP, VON) ebenfalls vorgesehen ist.

2. Sensorsystem nach Anspruch 1,
   bei dem die Sensoren (10, 11, 12, 13) Hall-Sensoren sind.

3. Sensorsystem nach einem der Ansprüche 1 oder 2,
   bei dem zwischen jedem Sensor (10, 11, 12, 13) und dem entsprechenden Signalmodulator (30, 31) ein Steilheitsverstärker (70, 71) geschaltet ist.

**4.** Sensorsystem nach einem der Ansprüche 1 bis 3,
bei dem die Signalmodulatoren (30, 31) parallel zueinander geschaltet sind.

**5.** Sensorsystem nach einem der Ansprüche 1 bis 4,
bei dem die Signalmodulatoren (30, 31) mit jeweils einer Kontroll-Logikschaltung (8) verbunden sind.

**6.** Sensorsystem nach Anspruch 5,
bei dem die Signalmodulatoren (30, 31) durch ein digitales Kontrollwort steuerbar sind.

**7.** Sensorsystem nach einem der Ansprüche 1 bis 6,
bei dem die Sensoren (10, 11, 12, 13) in einer Ebene angeordnet sind.

**8.** Sensorsystem nach einem der Ansprüche 1 bis 7,
bei dem die Sensoren (10, 11, 12, 13) in zueinander orthogonalen Zeilen und Spalten angeordnet sind.

**9.** Verfahren zum Betrieb eines Sensorsystems nach einem der Ansprüche 1 bis 8,
wobei die Steuerzustände der Signalmodulatoren (30, 31) die Konfiguration des Sensorsystems definieren,
mit folgenden Schritten:

> a) Einlesen und Speichern eines ersten Systemsignals (VOP, VON) bei einer ersten Konfiguration (K1)
> b) Ändern der Konfiguration des Sensorsystems in eine von der ersten Konfiguration (K1) verschiedene zweite Konfiguration (K2)
> c) Einlesen und Speichern eines zweiten Systemsignals (VOP, VON) bei der zweiten Konfiguration (K2)
> d) Durchführung einer Rechenoperation mit dem ersten und zweiten Systemsignal.

**10.** Verfahren nach Anspruch 9,
wobei nach Schritt c) und vor Schritt d) noch weitere Konfigurationen des Sensorsystems eingestellt und entsprechende Systemsignale (VOP, VON) eingelesen und gespeichert werden.

**Claims**

**1.** Sensor system with an arrangement of sensors (10, 11, 12, 13), wherein each sensor (10, 11, 12, 13) detects a magnetic or electrical field and outputs an electric basic sensor signal at its sensor outputs (21, 22, 23, 24),
**characterized in that** a signal modulator (30, 31) is provided, wherein the sensor outputs (21, 22) of each sensor (10, 11, 12, 13) are connected to the inputs (41, 42, 43, 44) of the signal modulator (30, 31), wherein the signal modulator (30, 31) has at least two control states, wherein in a first control state, the corresponding basic sensor signal is fed to the outputs (51, 52) of the signal modulator (30, 31) as a sensor end signal (iop, ion) and, in a second control state of the signal modulator (30, 31), the inverted basic sensor signal of the corresponding sensor (10, 11, 12, 13) is fed to the outputs (51, 52) of the signal modulator (30, 31) as a sensor end signal (iop, ion),

> - and that also a device (6) is provided for the addition of the sensor end signals (iop, ion) to a system signal (VOP, VON).

**2.** Sensor system according to claim 1, wherein the sensors (10, 11, 12, 13) are Hall sensors.

**3.** Sensor system according to one of claims 1 or 2, wherein an operational transconductance amplifier (70, 71) is connected between each sensor (10, 11, 12, 13) and the corresponding signal modulator (30, 31).

**4.** Sensor system according to one of claims 1 through 3, wherein the signal modulators (30, 31) are connected to one another in parallel.

**5.** Sensor system according to one of claims 1 through 4, wherein the signal modulators (30, 31) are each connected to a control logic circuit (8).

**6.** Sensor system according to claim 5,
wherein the signal modulators (30, 31) can be controlled by a digital control word.

7.  Sensor system according to one of claims 1 through 6, wherein the sensors (10, 11, 12, 13) are arranged in a plane.

8.  Sensor system according to one of claims 1 through 7, in which the sensors (10, 11, 12, 13) are arranged in rows and columns that are orthogonal to one another.

9.  Method to operate a sensor system according to one of claims 1 through 8, wherein the control states of the signal modulators (30, 31) define the configuration of the sensor system with the following steps:

    a) reading in and storing of a first system signal (VOP, VON) in the case of a first configuration (K1)
    b) modifying the configuration of the sensor system in a second configuration (K2) that is different from the first configuration (K1)
    c) reading in and storing a second system signal (VOP, VON) in the case of the second configuration (K2)
    d) performing an arithmetic operation with the first and second system signal.

10. Method according to claim 9, wherein after Step c) and before Step d) yet other configurations of the sensor system can be set, and corresponding system signals (VOP, VON) can be read in and stored.


**Revendications**

1.  Système de capteur ayant un agencement de capteurs (10, 11, 12, 13), dans lequel chaque capteur (10, 11, 12, 13) détecte un champ magnétique ou électrique et émet sur ses sorties (21, 22, 23, 24) de capteur un signal de base électrique de capteur, **caractérisé en ce que**

    - il est prévu un modulateur (30, 31) de signal, dans lequel les sorties (21, 22) de chaque capteur (10, 11, 12, 13) sont reliées aux entrées (41, 42, 43, 44) du modulateur (30, 31) de signal, le modulateur (30, 31) de signal ayant au moins deux états de commande, dans lequel dans un premier état de commande il s'applique aux sorties (51, 52) du modulateur (30, 31) de signal, comme signal (iop, ion) final de capteur, le signal de base de capteur correspondant et dans un deuxième état de commande du modulateur (30, 31) de signal, il s'applique sur ses sorties (51, 52), comme signal (iop, ion) final de capteur, le signal de base inversé du capteur (10, 11, 12, 13) correspondant,
    - et **en ce qu'**il est prévu également un dispositif (6) d'addition des signaux (iop, ion) de capteur en un signal (VOP, VON) de système.

2.  Système de capteur suivant la revendication 1,
    dans lequel les capteurs (10, 11, 12, 13) sont des capteurs Hall.

3.  Système de capteur suivant l'une des revendications 1 ou 2,
    dans lequel il est monté entre chaque capteur (10, 11, 12, 13) et le modulateur (30, 31) de signal correspondant un amplificateur (70, 71) de pente.

4.  Système de capteur suivant l'une des revendications 1 à 3,
    dans lequel les modulateurs (30, 31) de signal sont montés en parallèle les uns avec les autres.

5.  Système de capteur suivant l'une des revendications 1 à 4,
    dans lequel les modulateurs (30, 31) de signal sont reliés respectivement à un circuit (8) logique de contrôle.

6.  Système de capteur suivant la revendication 5,
    dans lequel les modulateurs (30, 31) de signal peuvent être commandés par un mot de contrôle numérique.

7.  Système de capteur suivant l'une des revendications 1 à 6,
    dans lequel les capteurs (10, 11, 12, 13) sont disposés dans un plan.

8.  Système de capteur suivant l'une des revendications 1 à 7,
    dans lequel les capteurs (10, 11, 12, 13) sont disposés en des lignes et des colonnes orthogonales entre elles.

9.  Procédé pour faire fonctionner un système de capteur suivant l'une des revendications 1 à 8,
    dans lequel les états de commande des modulateurs (30, 31) de signal définissent la configuration du système de capteur,

comprenant les stades suivants :

a) on lit et on mémorise un premier signal (VOP, VON) de système dans une première configuration (K1)

b) on modifie la configuration du système de capteur en une deuxième configuration (K2) différente de la première configuration (K1)

c) on lit et on mémorise un deuxième signal (VOP, VON) de système dans la deuxième configuration (K2)

d) on effectue l'opération de calcul avec le premier et le deuxième signal de système.

**10.** Procédé suivant la revendication 9,
dans lequel, après le stade c) et avant le stade d) on établit encore d'autres configurations du système de capteur et on lit et on mémorise des signaux (VOP, VON) de système correspondants.

# FIG 1

# FIG 2

## FIG 3A

Q3

10

+

Q0

11

+

13

−

−

12

Q2

Q1

## FIG 3B

Q3

10

−

Q0

11

+

+

13

−

12

Q2

Q1

FIG 4A

FIG 4B

FIG 4C

FIG 4D